# EUROPÄISCHE PATENTSCHRIFT

(11) **EP 3 685 425 B1**
(45) Veröffentlichungstag und Bekanntmachung des Hinweises auf die Patenterteilung: **13.04.2022**
(21) Anmeldenummer: 18782651.6
(22) Anmeldetag: 19.09.2018
(51) Int. Cl.: H01J 37/32, A23L 3/01, H05B 6/70

(54) **VORRICHTUNG ZUR BEHANDLUNG EINES PRODUKTS MIT MIKROWELLEN**
DEVICE FOR TREATING A PRODUCT WITH MICROWAVES
DISPOSITIF POUR TRAITER UN PRODUIT AU MOYEN DE MICRO-ONDES

(30) Priorität: 19.09.2017 DE 102017121732
(43) Veröffentlichungstag der Anmeldung: 29.07.2020
(73) Patentinhaber: Muegge GmbH, 64385 Reichelsheim (DE)
(72) Erfinder: BAARS, Daniel, 64407 Fränkisch-Crumbach (DE); REICHMANN, Markus, 64720 Michelstadt-Rehbach (DE); BAUMGÄRTNER, Klaus-Martin, 64395 Brensbach (DE); VOIT, Niko, 64750 Lützelbach (DE)
(74) Vertreter: Habermann Intellectual Property Partnerschaft von Patentanwälten mbB
(86) Internationale Anmeldenummer: PCT/EP2018/075264
(87) Internationale Veröffentlichungsnummer: WO 2019/057734

(56) Entgegenhaltungen:
- WO-A1-00/75955
- US-A1- 2017 231 035

## Beschreibung

Die Erfindung betrifft eine Vorrichtung zur Behandlung eines Produkts mit Mikrowellen, wobei die Vorrichtung einen Behandlungsraum, in welchem das Produkt angeordnet werden kann, und eine in dem Behandlungsraum angeordnete Mikrowellenabstrahleinrichtung aufweist, mit welcher in die Mikrowellenabstrahleinrichtung eingekoppelte Mikrowellen abgestrahlt werden können, die auf das Produkt einwirken.

Es ist aus der Praxis bekannt, dass Mikrowellen zur Erwärmung von Produkten, beispielsweise von Lebensmitteln und zubereiteten Speisen verwendet werden können. Zu diesem Zweck werden Mikrowellen mit einer geeigneten Mikrowellenfrequenz in einen Behandlungsraum abgestrahlt, in dem sich das zu erwärmende Produkt befindet. Die in den Behandlungsraum abgestrahlten und in das dort befindlich Produkt eindringenden Mikrowellen erzeugen in dem Produkt Wärme, wobei die Erwärmung beispielsweise durch die eingestrahlte Mikrowellenleistung und durch die Dauer der Mikrowelleneinstrahlung vorgeben bzw. variiert werden kann.

Es ist ebenfalls bekannt, dass Mikrowellen zur Erwärmung industrieller Produkte während eines Herstellungsvorgangs oder einer Weiterverarbeitung der Produkte verwendet werden können. Mikrowellen können auch zur Sterilisierung und Haltbarmachung von Nahrungsmitteln oder Fertiggerichten verwendet werden, da mit einer ausreichend intensiven Mikrowelleneinstrahlung innerhalb kurzer Zeit eine sehr starke Erwärmung von Produkten möglich ist.

Bei aus der Praxis bekannten Behandlungsvorrichtungen kann die Mikrowelle über Hohlleiter in einen Behandlungsraum eingekoppelt werden, in welchem das zu behandelnde Produkt angeordnet ist. Der Behandlungsraum kann in Abhängigkeit von der verwendeten Mikrowellenfrequenz geeignete Abmessungen aufweisen, sodass der Behandlungsraum einen Resonator bildet und die Ausbildung von stehenden Wellen im Behandlungsraum ermöglicht bzw. begünstigt. Es wird jedoch als ein erheblicher Nachteil empfunden, dass bei räumlich ausgedehnten Produkten in derartigen Behandlungsräumen regelmäßig nur eine ungleichmäßige Erwärmung eines Produkts möglich ist, da die räumliche Verteilung der Mikrowellenergie innerhalb des Behandlungsraums insbesondere bei der Ausbildung von stehenden Wellen sehr ungleichmäßig ist.

Es ist ebenfalls aus der Praxis bekannt, dass die Mikrowellen über Hornstrahler in den Behandlungsraum eingekoppelt bzw. in dem Behandlungsraum auf das Produkt gerichtet abgestrahlt werden können. Auch bei derartigen Behandlungsvorrichtungen wird oftmals eine vergleichsweise ungleichmäßige Erwärmung eines in dem Behandlungsraum angeordneten Produkts festgestellt.

Aus DE 101 57 601 B4 ist eine Vorrichtung zur Behandlung eines Produkts mit Mikrowellen bekannt, bei der eine in dem Behandlungsraum angeordnete Mikrowellenabstrahleinrichtung eine Stabantenne aufweist, entlang der sich eine eingekoppelte Mikrowellenstrahlung ausbreitet und dabei radial in die Umgebung der Stabantenne abgestrahlt wird. Durch geeignet angeordnete Abschirmungen kann ein Anteil der Mikrowellenstrahlung, der von der Stabantenne in eine von dem Produkt abgewandten Richtung abgestrahlt wird, reflektiert und in Richtung des Produkts zurückgerichtet werden. Auf diese Weise kann ein vergleichsweise hoher Anteil der Mikrowellenstrahlung auf das Produkt gerichtet und zur Behandlung des Produkts verwendet werden. Durch die Verwendung der Stabantenne wird in axialer Richtung eine Ausbreitung der Mikrowellen längs der Stabantenne begünstigt und dadurch über eine axiale Erstreckung der Stabantenne hinweg die Abstrahlung von Mikrowellen in den Behandlungsraum ermöglicht, wobei diese Erstreckung deutlich größer als bei Hornstrahlern sein kann. Es hat sich jedoch gezeigt, dass auch bei der Verwendung einer Stabantenne die eingekoppelten Mikrowellen in axiale Richtungen längs der Stabantenne eine ungleichmäßige Mikrowellenabstrahlung erzeugen und ein benachbart zu der Stabantenne angeordnetes Produkt entsprechend ungleichmäßig erwärmt bzw. behandelt wird. Weitere bekannte Vorrichtungen zur Behandlung eines Produktes mit Mikrowellen sind in den Patentschriften WO 00/75955 A1 und US 2017/231035 A offenbart.

Es wird deshalb als eine Aufgabe der vorliegenden Erfindung angesehen, eine Vorrichtung zur Behandlung eines Produkts mit Mikrowellen so auszugestalten, dass mit einem möglichst geringen konstruktiven Aufwand eine möglichst gleichmäßige und effektive Behandlung eines in dem Behandlungsraum angeordneten Produkts mit Mikrowellen ermöglicht wird.

Diese Aufgabe wird erfindungsgemäß durch eine Vorrichtung gemäß Anspruch 1 gelöst. Weitere erfinderische Ausführung sind in den Ansprüche 2-4 offenbart. Die Mikrowellenabstrahleinrichtung weist einen in den Behandlungsraum ragenden Koaxialleiter mit einem elektrisch leitenden Innenleiter und mit einem elektrisch leitenden Außenleiter auf, wobei der Außenleiter koaxial angeordnet den Innenleiter beabstandet umgibt und mindestens eine Öffnung aufweist, die eine Abstrahlung von Mikrowellen durch die Öffnung hindurch auf das Produkt ermöglicht. In den Koaxialleiter eingekoppelte Mikrowellen können sich in Längsrichtung des Koaxialleiters nahezu verlustfrei ausbreiten, sodass über die gesamte Länge des Koaxialleiters hinweg eine im Wesentlichen gleichbleibend große Mikrowellenleistung zur Verfügung steht. Der den Innenleiter umgebende Außenleiter verhindert eine radiale Abstrahlung der in den Koaxialleiter eingekoppelten Mikrowellen. Die eingekoppelten Mikrowellen können nur im Bereich der mindestens einen Öffnung in dem Außenleiter aus dem Koaxialleiter austreten und aus dem Koaxialleiter abgestrahlt werden.

Der Koaxialleiter ist derart in den Behandlungsraum angeordnet, dass die in dem Außenleiter befindliche Öffnung in Richtung des Produkts ausgerichtet ist und die aus dem Koaxialleiter austretende Mikrowellenstrahlung auf das Produkt gerichtet ist. Bei kleinen Produktabmessungen kann bereits eine Öffnung in dem Außenleiter ausreichen, um eine effiziente und vergleichsweise gleichmäßige Behandlung des Produkts mit den durch die Öffnung abgestrahlten Mikrowellen zu ermöglichen. Die Abmessungen der Öffnung sind dabei zweckmäßigerweise derart an eine Frequenz der eingekoppelten Mikrowelle angepasst, dass eine räumlich möglichst homogene Abstrahlung von Mikrowellen aus dem Koaxialleiter durch die Öffnung hindurch bewirkt wird.

Im Hinblick auf eine möglichst effiziente Abstrahlung von Mikrowellen aus dem Koaxialleiter ist optional vorgesehen, dass der Koaxialleiter so ausgebildet ist, dass die eingekoppelten Mikrowellen stehende Wellen in dem Koaxialleiter ausbilden, und dass die mindestens eine Öffnung in axialer Richtung in einem Bereich eines elektrischen Feldstärkeknotens angeordnet ist. In einem Bereich eines elektrischen Feldstärkeknotens sind die durch die Mikrowellen erzeugten Oberflächenströme am höchsten, sodass bei einer in diesem Bereich angeordneten Öffnung eine größtmögliche Auskopplung der sich zunächst innerhalb des Koaxialleiters ausbreitenden Mikrowellen ermöglicht wird.

Der Koaxialleiter kann an einem der einen Kopplung der Mikrowellen entgegengesetzten Ende entweder als offener Koaxialleiter ausgebildet sein, wobei der Innenleiter an dem Ende keine elektrisch leitende Verbindung mit dem Außenleiter aufweist, oder aber eine elektrisch leitende Verbindung aufweisen, sodass an dem Ende des Koaxialleiters der Außenleiter und der Innenleiter kurzgeschlossen sind und das gleiche elektrische Potenzial aufweisen. Eine Länge des Koaxialleiters von der Einkopplung der Mikrowellen bis zu dem offenen oder kurzgeschlossenen Ende ist in vorteilhafter Weise an die Frequenz der eingekoppelten Mikrowellen angepasst, um die Ausbildung von stehenden Wellen in dem Koaxialleiter zu begünstigen.

In vielen Fällen kann insbesondere zur Erwärmung von Nahrungsmittel oder wasserhaltigen Produkten eine Mikrowellenfrequenz von 2,45 GHz verwendet werden. Eine Wellenlänge der Mikrowellen beträgt bei dieser Mikrowellenfrequenz etwa 12 cm. In axialer Richtung des Koaxialleiters befinden sich dann elektrische Feldstärkeknoten mit einem Abstand von jeweils einer halben Wellenlänge bzw. von jeweils etwa 6 cm.

Gemäß einer vorteilhaften Ausgestaltung des Erfindungsgedankens ist vorgesehen, dass der Koaxialleiter zwei und oder mehr Öffnungen aufweist, die in axialer Richtung einen Abstand zueinander aufweisen, der ein ganzzahliges Vielfaches der halben Wellenlänge der Mikrowellen ist. Wenn der Koaxialleiter an die Verwendung von Mikrowellen mit einer Frequenz von beispielsweise 2,45 GHz angepasst ist, kann der Koaxialleiter in axialer Richtung mehrere Öffnungen aufweisen, die jeweils etwa 6 cm voneinander beabstandet und jeweils im Bereich eines elektrischen Feldstärkeknotens angeordnet sind, wodurch eine vergleichsweise effiziente Auskopplung der in den Koaxialleiter eingekoppelten Mikrowellen ermöglicht wird. Eine einzelne Öffnung weist dabei zweckmäßigerweise Abmessungen von weniger als einer halben Wellenlänge, bzw. einen maximalen Öffnungsdurchmesser auf, der in axialer Richtung deutlich geringer als eine halbe Wellenlänge der Mikrowellen ist und beispielsweise weniger als ein Viertel, ein Sechstel oder ein Achtel der Wellenlänge der Mikrowellen ist.

Da sich die Mikrowellen innerhalb des Koaxialleiters in axialer Richtung nahezu verlustfrei ausbreiten können, kann über die gesamte Länge des Koaxialleiters hinweg eine Anzahl von Öffnungen angeordnet sein. Der jeweilige Abstand der Öffnungen zu benachbarten Öffnungen kann dabei in vorteilhafterweise eine halbe Wellenlänge der eingekoppelten Mikrowellen betragen, jedoch sind auch andere Abstände zueinander möglich. Um eine möglichst gleichmäßige Abstrahlung von Mikrowellen durch die mehreren Öffnungen zu bewirken können beispielsweise die jeweilige Größe der Öffnungen oder deren Ausrichtung sowie die jeweilige Anordnung der Öffnungen in axialer Richtung und deren jeweilige Ausrichtung in Richtung des zu behandelnden Produkts an das betreffende Produkt und dessen Anordnung relativ zu dem Koaxialleiter angepasst sein.

Gemäß einer optionalen Ausgestaltung des Erfindungsgedankens ist vorgesehen, dass die mindestens eine Öffnung sich in Umfangsrichtung des Außenleiters über weniger als einen halben Umfang erstreckt. Die mindestens eine Öffnung ist zweckmäßigerweise in Richtung des in dem Behandlungsraum angeordneten Produkts ausgerichtet. Durch die Ausrichtung der Öffnung kann eine entsprechend gerichtete Abstrahlung der Mikrowellen aus dem Koaxialleiter vorgegeben werden. Je größer die Erstreckung einer Öffnung in Umfangsrichtung ist, umso stärker ist die durch diese Öffnung bewirkte Auskopplung von Mikrowellenstrahlung, jedoch ist eine in vielen Fällen wünschenswerte Fokussierung und Ausrichtung der Mikrowellenabstrahlung bei einer großen Öffnung geringer als bei einer kleinen Öffnung.

Gemäß der Ausgestaltung des Erfindungsgedankens ist vorgesehen, dass in einem Innenraum zwischen dem Innenleiter und dem Außenleiter ein hohlzylinderförmiger dielektrischer Festkörper angeordnet ist, dessen Permittivität größer als die Permittivität von Luft ist. Der dielektrische Festkörper weist in zweckmäßiger Weise bei der für den Betrieb vorgesehenen Mikrowellenfrequenz einen möglichst geringen dielektrischen Verlustfaktor auf. Durch den hohlzylinderförmigen dielektrischen Festkörper wird der Innenraum zwischen dem Innenleiter und dem Außenleiter im Wesentlichen vollständig ausgefüllt. Allerdings ist es sowohl aus Toleranzgründen als auch wegen der unterschiedlichen thermischen Ausdehnungskoeffizienten des Materials des Innenleiters und des Außenleiters einerseits und des dielektrischen Festkörpers andererseits zweckmäßig, dass zumindest um den Innenleiter herum ein kleiner Schlitz verbleibt. Der dielektrische Festkörper weist in radialer Richtung einen geringen Abstand zumindest zu dem Innenleiter und gegebenenfalls auch zu dem Außenleiter auf, sodass der dielektrische Festkörper entweder über die gesamte Umfangsfläche oder zumindest bereichsweise einen geringen Abstand zu dem Innenleiter bzw. gegebenenfalls stattdessen oder zusätzlich zu dem Außenleiter aufweist.

Im Hinblick auf eine möglichst effiziente Abstrahlung der Mikrowellen durch die Öffnung ist es gemäß der Erfindung vorgesehen, dass der dielektrische Festkörper im Bereich der mindestens einen Öffnung eine nach innen ragende oder nach außen vorspringende Ausformung aufweist. Durch einen geeigneten Konturverlauf des dielektrischen Festkörpers im Bereich der Öffnung und insbesondere in einem Übergangsbereich längs eines Umfangsrands der Öffnung kann eine Eingangsimpedanz des Koaxialleiters auf eine Ausgangsimpedanz des umgebenden Mediums in dem Behandlungsraum abgestimmt werden, um eine möglichst vorteilhafte Auskopplung der Mikrowellen aus dem Koaxialleiter in den Behandlungsraum zu ermöglichen.

Nachfolgend wird ein exemplarisch dargestelltes Ausführungsbeispiel des Erfindungsgedankens näher erläutert, das in der Zeichnung schematisch dargestellt ist. Es zeigt:
Fig. 1 eine perspektivische Ansicht eines erfindungsgemäßen Koaxialleiters,
Fig. 2 eine Schnittansicht des in Fig. 1 gezeigten Koaxialleiters längs einer Schnittebene II-II in Fig. 1,
Fig. 3 eine Schnittansicht des in Fig. 1 gezeigten Koaxialleiters längs einer Schnittebene III-III in Fig. 1,
Fig. 4 eine weitere Schnittansicht des in Fig. 1 gezeigten Koaxialleiters längs einer Schnittebene IV-IV in Fig. 1, und
Fig. 5 eine schematische Darstellung der erfindungsgemäßen Vorrichtung mit einem Behandlungsraum, mit einem in dem Behandlungsraum angeordneten Produkt und mit einem über dem Produkt angeordneten Koaxialleiter.

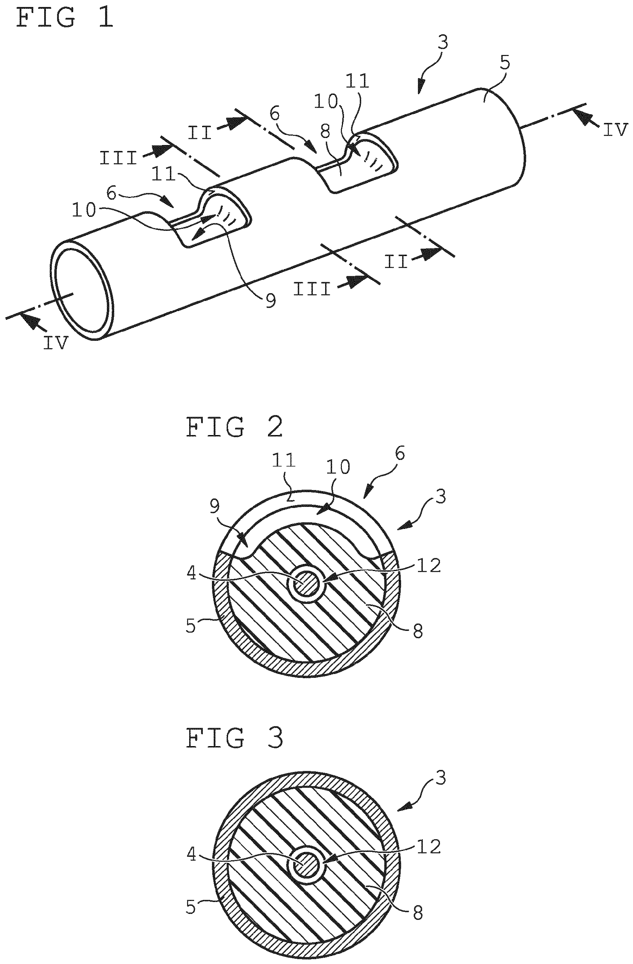

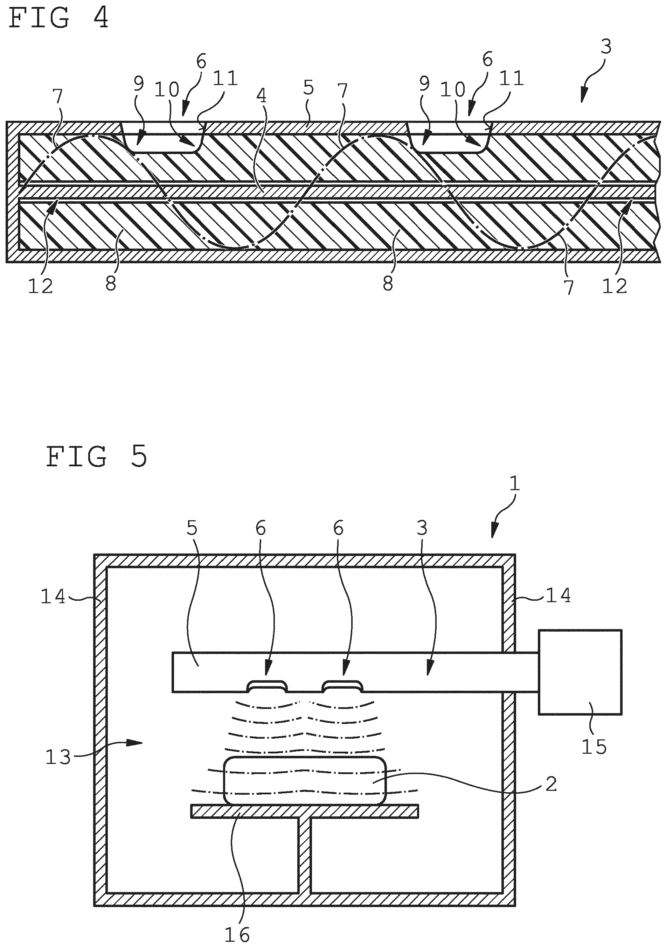

Eine in Figur 5 schematisch dargestellte Vorrichtung 1 zur Behandlung eines Produkts 2 mit Mikrowellen weist einen in den Figuren 1 bis 4 in verschiedenen Ansichten dargestellten Koaxialleiter 3 auf. Der Koaxialleiter 3 weist einen elektrisch leitenden Innenleiter 4 und einen koaxial um den Innenleiter 4 herum angeordneten hohlzylinderförmigen und elektrisch leitenden Außenleiter 5 auf. Der Koaxialleiter 3 kann in axialer Richtung eine Länge von einigen wenigen Zentimetern bis zu mehr als 50 cm oder 1 m aufweisen. Sowohl die Länge des Koaxialleiters 3 als auch die radialen Abmessungen des Innenleiters 4 und insbesondere des Außenleiters 5 sind dabei zweckmäßigerweise an die Frequenz bzw. Wellenlänge der Mikrowellen angepasst, die während eines Betriebs der Vorrichtung 1 in den Koaxialleiter 3 eingekoppelt werden sollen.

Der Außenleiter 5 weist bei dem exemplarisch dargestellten Ausführungsbeispiel zwei Öffnungen 6 auf. Der Außenleiter 5 könnte jedoch auch nur eine Öffnung 6 oder aber mehr als zwei Öffnungen 6 aufweisen. Die beiden Öffnungen 6 erstrecken sich in Umfangsrichtung jeweils über etwas weniger als einen halben Umfang des Außenleiters 5. In axialer Richtung sind die beiden Öffnungen 6 bei dem dargestellten Ausführungsbeispiel etwa eine Wellenlänge der während des Betriebs eingespeisten Mikrowellen mit einer vorgegebenen Mikrowellenfrequenz beabstandet. Wenn beispielsweise eine für die Erwärmung von Nahrungsmitteln vorteilhafte Mikrowellenfrequenz von 2,45 GHz verwendet wird, beträgt der Abstand der beiden Öffnungen 6 in axialer Richtung etwa 12 cm.

Zweckmäßigerweise ist ein Abstand zwischen den beiden Öffnungen 6 so gewählt, dass der Abstand ein Vielfaches der halben Wellenlänge der mit der vorgegebenen Mikrowellenfrequenz eingespeisten Mikrowellen beträgt, wobei jede der Öffnungen 6 im Bereich eines elektrischen Feldstärkeknotens angeordnet ist. Die Länge des Koaxialleiters 3 ist dabei in vorteilhafterweise so vorgegeben, dass die eingekoppelten Mikrowellen eine stehende Welle in dem Koaxialleiter 3 bildet. In Figur 4 sind die räumlichen Abmessungen des Koaxialleiters 3 und der in dessen Außenleiter 5 angeordneten Öffnungen 6 schematisch in Beziehung zu einem angedeuteten Verlauf 7 einer sich in dem Koaxialleiter 3 ausbildenden stehenden Welle der eingekoppelten Mikrowellen dargestellt.

Zwischen dem Innenleiter 4 und dem Außenleiter 5 ist ein hohlzylinderförmiger dielektrischer Festkörper 8 angeordnet. Der dielektrische Festkörper 8 besteht beispielsweise aus Polyethylen oder aus Polytetrafluorethylen und weist eine deutlich höhere Permittivität als Luft sowie eine vergleichsweise geringe dielektrische Verlustleistung für die eingekoppelten Mikrowellen auf. Der dielektrische Festkörper 8 erhöht zudem die mechanische Festigkeit des Koaxialleiters 3.

In einem durch die Öffnungen 6 des Außenleiters 5 vorgegebenen Bereich weist der Festkörper 8 jeweils eine nach innen ragende Ausformung 9 auf. Eine Formgebung der Ausformungen 9 ist insbesondere in einem Übergangsbereich 10 längs eines Umfangsrandes 11 der Öffnungen 6 so ausgestaltet, dass eine möglichst effektive Auskopplung der Mikrowellen aus dem Koaxialleiter 3 durch die Öffnungen 6 hindurch in die Umgebung ermöglicht wird.

Zwischen dem Innenleiter 4 und dem umgebenden dielektrischen Festkörper 8 ist ein kleiner Ringspalt 12 vorgesehen, um einerseits toleranzbedingte Schwankungen der jeweiligen Abmessungen während der Herstellung des Koaxialleiters 3 ausgleichen zu können und andererseits während eines Betriebs die unterschiedlichen Ausdehnungen des Innenleiters 4 und des dielektrischen Festkörpers 8 auf Grund der unterschiedlichen thermischen Ausdehnungskoeffizienten der jeweils verwendeten Materialien ausgleichen zu können.

In Figur 5 ist schematisch die Vorrichtung 1 mit einem einen Behandlungsraum 13 umgebenden Gehäuse 14 dargestellt. Der Koaxialleiter 3 ragt von außen in den Behandlungsraum 13. Geeignete Mikrowellen können über eine Einkopplungseinrichtung 15 von außerhalb des Behandlungsraums 13 in den Koaxialleiter 3 eingekoppelt werden. Auf einer in dem Behandlungsraum 13 angeordneten Produktplattform 16 befindet sich das zu behandelnde Produkt 2. Der Koaxialleiter 3 und insbesondere die Öffnungen 6 in dem Koaxialleiter 3 sind so ausgerichtet, dass das Produkt 2 vollständig und zumindest nahezu homogen durch die aus den beiden Öffnungen 6 austretende Mikrowellenstrahlung bestrahlt und dadurch gleichmäßig erwärmt werden kann.

Die Anzahl der Öffnungen 6 und die Länge des Koaxialleiters 3 können dabei in geeigneter Weise an die Abmessungen des Produkts 2 angepasst sein. Es ist ebenfalls denkbar, dass mehrere Koaxialleiter 3 in den Behandlungsraum 13 ragen oder darin angeordnet sind, um das Produkt 2 mit abgestrahlten Mikrowellen zu behandeln. Bei mehreren Koaxialleitern 3 können die einzelnen Koaxialleiter 3 und die jeweiligen Öffnungen 6 so angeordnet und ausgerichtet sein, dass eine sehr homogene Bestrahlung des Produkts 2 mit den aus den Öffnungen 6 abgestrahlten Mikrowellen erfolgt.

Bei dem Produkt 2 kann es sich beispielsweise um Nahrungsmittel oder um Fertiggerichte handeln, die durch die Mikrowellenstrahlung kurzzeitig erhitzt und dadurch haltbar gemacht oder sterilisiert werden sollen. Es ist ebenfalls denkbar, dass andere industrielle Produkte wie beispielsweise Bauteile oder Komponenten mit der erfindungsgemäßen Vorrichtung behandelt und dabei verarbeitet oder weiterverarbeitet werden.

## Patentansprüche

1. Vorrichtung (1) zur Behandlung eines Produkts (2) mit Mikrowellen, wobei die Vorrichtung (1) einen Behandlungsraum (13), in welchem das Produkt (2) angeordnet werden kann, und eine in dem Behandlungsraum (13) angeordnete Mikrowellenabstrahleinrichtung aufweist, mit welcher in die Mikrowellenabstrahleinrichtung eingekoppelte Mikrowellen abgestrahlt werden können, die auf das Produkt (2) einwirken, wobei die Mikrowellenabstrahleinrichtung einen in den Behandlungsraum (13) ragenden Koaxialleiter (3) mit einem elektrisch leitenden Innenleiter (4) und mit einem elektrisch leitenden Außenleiter (5) aufweist, und wobei der Außenleiter (5) koaxial angeordnet den Innenleiter (4) beabstandet umgibt und mindestens eine Öffnung (6) aufweist, die eine Abstrahlung von Mikrowellen durch die Öffnung (6) hindurch auf das Produkt (2) ermöglicht, wobei
in einem Innenraum zwischen dem Innenleiter (4) und dem Außenleiter (5) ein hohlzylinderförmiger dielektrischer Festkörper (8) angeordnet ist, dessen Permittivität größer als die Permittivität von Luft ist, und die in dem Außenleiter (5) befindliche Öffnung (6) in Richtung des Produkts (2) ausgerichtet ist und die aus dem Koaxialleiter austretende Mikrowellenstrahlung auf das Produkt (2) gerichtet ist, **dadurch gekennzeichnet, dass** der dielektrische Festkörper (8) im Bereich der mindestens einen Öffnung (6) eine nach innen ragende oder nach außen vorspringende Ausformung (9) aufweist.

2. Vorrichtung (1) nach Anspruch 1, **dadurch gekennzeichnet, dass** der Koaxialleiter (3) so ausgebildet ist, dass die eingekoppelten Mikrowellen stehende Wellen in dem Koaxialleiter (3) ausbilden, und dass die mindestens eine Öffnung (6) in axialer Richtung in einem Bereich eines elektrischen Feldstärkeknotens angeordnet ist.

3. Vorrichtung (1) nach Anspruch 1 oder Anspruch 2, **dadurch gekennzeichnet, dass** der Koaxialleiter (3) zwei oder mehr Öffnungen (6) aufweist, die in axialer Richtung einen Abstand zueinander aufweisen, der ein ganzzahliges Vielfaches der halben Wellenlänge der Mikrowellen ist.

4. Vorrichtung (1) nach einem der vorausgehenden Ansprüche, **dadurch gekennzeichnet, dass** die mindestens eine Öffnung (6) sich in Umfangsrichtung des Außenleiters (5) über weniger als einen halben Umfang erstreckt und dass die mindestens eine Öffnung (6) in Richtung des in dem Behandlungsraum (13) angeordneten Produkts (2) ausgerichtet ist.

## Claims

1. Device (1) for treating a product (2) with microwaves, wherein the device (1) comprises a treatment chamber (13) in which the product (2) can be arranged, and a microwave-radiating apparatus, which can be used to radiate microwaves injected into the microwave-radiating apparatus, arranged in the treatment chamber (13), which microwaves act on the product (2), wherein the microwave-radiating apparatus comprises a coaxial conductor (3) projecting into the treatment chamber (13), with an electrically conductive inner conductor (4) and with an electrically conductive outer conductor (5), wherein the outer conductor (5) surrounds the inner conductor (4) at a distance in a coaxially arranged manner and comprises at least one opening (6) that allows microwaves to be radiated through the opening (6) on to the product (2), wherein a hollow cylindrical dielectric solid (8), the permittivity of which is greater than the permittivity of air, is arranged in an inner chamber between the inner conductor (4) and the outer conductor (5), and the opening (6) in the outer conductor (5) is oriented towards the product (2), and the microwave radiation issuing from the coaxial conductor is directed on to the product (2), **characterised in that** the dielectric solid (8) comprises an inwardly projecting or outwardly protruding formation (9) in the region of the at least one opening (6).

2. Device (1) according to claim 1, **characterised in that** the coaxial conductor (3) is configured such that the injected microwaves form standing waves in the coaxial conductor (3), and **in that** the at least one opening (6) is arranged in the axial direction in a region of an electrical field strength node.

3. Device (1) according to claim 1 or claim 2, **characterised in that** the coaxial conductor (3) comprises two or more openings (6) that are at a distance from each other in the axial direction, which distance is an integral multiple of the half wavelength of the microwaves.

4. Device (1) according to one of the preceding claims, **characterised in that** the at least one opening (6) extends over less than half a circumference in the circumferential direction of the outer conductor (5), and **in that** the at least one opening (6) is oriented towards the product (2) arranged in the treatment chamber (13).

## Revendications

1. Dispositif (1) pour le traitement d'un produit (2) avec des micro-ondes, dans lequel le dispositif (1) présente un espace de traitement (13), dans lequel le produit (2) peut être disposé, et un système d'émission de micro-ondes disposé dans l'espace de traitement (13), avec lequel peuvent être émises des micro-ondes injectées dans le dispositif d'émission de micro-ondes, qui agissent sur le produit (2), dans lequel le dispositif d'émission de micro-ondes présente un conducteur coaxial (3) dépassant dans l'espace de traitement (13) avec un conducteur intérieur (4) électriquement conducteur et avec un conducteur extérieur (5) électriquement conducteur, et dans lequel le conducteur extérieur (5) entoure à distance, disposé de manière coaxiale, le conducteur intérieur (4) et présente au moins une ouverture (6), qui permet une émission de micro-ondes à travers l'ouverture (6) sur le produit (2), dans lequel est disposé dans un espace intérieur entre le conducteur intérieur (4) et le conducteur extérieur (5) un corps solide (8) diélectrique en forme de cylindre creux, dont la permittivité est supérieure à la permittivité de l'air, et l'ouverture (6) se trouvant dans le conducteur extérieur (5) est orientée en direction du produit (2) et le rayonnement de micro-ondes sortant du conducteur coaxial est dirigé sur le produit (2), **caractérisé en ce que** le corps solide (8) diélectrique présente dans la zone de l'au moins une ouverture (6) une déformation (9) dépassant vers l'intérieur ou faisant saillie vers l'extérieur.

2. Dispositif (1) selon la revendication 1, **caractérisé en ce que** le conducteur coaxial (3) est réalisé de telle sorte que les micro-ondes injectées forment des ondes stationnaires dans le conducteur coaxial (3), et que l'au moins une ouverture (6) est disposée dans une direction axiale dans une zone d'un nœud à intensité de champ électrique.

3. Dispositif (1) selon la revendication 1 ou la revendication 2, **caractérisé en ce que** le conducteur coaxial (3) présente deux ouvertures (6) ou plus, qui présentent dans une direction axiale une distance l'une par rapport à l'autre, qui est un multiple entier de la moitié de la longueur d'onde des micro-ondes.

4. Dispositif (1) selon l'une quelconque des revendications précédentes, **caractérisé en ce que** l'au moins une ouverture (6) s'étend dans la direction périphérique du conducteur extérieur (5) sur moins d'une demi-périphérie, et que l'au moins une ouverture (6) est orientée en direction du produit (2) disposé dans l'espace de traitement (13).
